# EUROPÄISCHE PATENTSCHRIFT

(11) **EP 2 264 469 B1**
(45) Veröffentlichungstag und Bekanntmachung des Hinweises auf die Patenterteilung: **04.11.2015**
(21) Anmeldenummer: 10011552.6
(22) Anmeldetag: 02.12.2004
(51) Int. Cl.: G01R 22/06

(54) **Anschlusssystem für Stromzähler**
Connection system for electricity meters
Système de raccordement pour compteurs d'électricité

(30) Priorität: 16.12.2003 DE 10359139
(43) Veröffentlichungstag der Anmeldung: 22.12.2010
(62) Teilanmeldung aus: 04028522.3
(73) Patentinhaber: Hager Electro GmbH & Co. KG, 66440 Blieskastel (DE)
(72) Erfinder: Kelaiditis, Konstantin, Dr.-Ing., 66386 St. Ingbert (DE); Zimmermann, Michael, 66130 Saarbrücken (DE); Clemens, Guntram, Dr.-Ing., 31787 Hameln (DE)
(74) Vertreter: Nuss, Laurent

(56) Entgegenhaltungen:
- DE-A1- 4 116 218
- DE-U1- 20 216 393
- DE-U1- 29 703 981
- US-A- 2 086 495
- US-A- 2 412 558
- US-A- 3 628 097
- US-A- 5 586 913
- US-A- 5 704 804
- US-A1- 2002 030 964
- US-B1- 6 475 028

## Beschreibung

Die Erfindung betrifft ein Anschlusssystem für elektronische Stromzähler gemäß Oberbegriff des Anspruchs 1.

Die hier einbezogenen Patentanmeldungen 102 61 206.4, 103 13 999.0, 103 23 161.7, 103 23 160.9 und 103 24 355.0 beschreiben Anschlussvorrichtungen für elektronische Stromzähler, deren Verbindungs- und Anschlusselemente sich von herkömmlichen Zählern unterscheiden. Gemäß der 102 61 206.4 ist ein Zähler über einen Adapter an eine Zählertragplatte für herkömmliche Zähler anschließbar, wobei der Adapter am Zöhlerkreuz der Zählertragplatte befestigt wird.

Die US 5 704 804 beschreibt ein Anschlusssystem für einen Stromzähler mit einer an einer Trägerwand installierbaren Aufnahmebaugruppe, auf die ein Stromzähler senkrecht zur Trägerwand unter elektrischer Verbindung mit der Aufnahmebaugruppe aufsteckbar ist.

Von einer Anschlussleiste an der Unterseite der Aufnahmebaugruppe erstreckt sich ein U-förmiger Neutralleiter in das Gehäuse der Aufnahmebaugruppe hinein und wieder zu der Unterseite zu der Anschlussleiste zurück. Der U-förmige Neutralleiter ist über ein flexibles Kabel mit einem durch ein Kontaktstück des Stromzählers kontaktierbaren Steckanschlusselement verbunden.

Aus der US 2 086 495 und der US 3 628 097 gehen Aufnahmebaugruppen für Stromzähler mit mehreren Anschlussplätzen hervor, wobei sämtliche Anschlussplätze durch gemeinsame Busleitungen, darunter einen Neutralleiter, versorgt werden. An jedem Anschlussplatz sind gesonderte, aus einem Gehäuse der Aufnahmebaugruppe herausführbare Leitungen für die Bildung von Stromkreisen vorgesehen, wobei durch den an dem betreffenden Anschlussplatz installierten Stromzähler der Elektroenergieverbrauch in dem jeweiligen Stromkreis messbar ist.

Der vorliegenden Erfindung liegt die Aufgabe zugrunde, ein neues Anschlusssystem für Stromzähler zu schaffen, das insbesondere den sich für elektronische Stromzähler stellenden Anforderungen gerecht wird.

Diese Aufgabe wird durch die Merkmale des Anspruchs 1 gelöst.

Gemäß der Erfindung ist ein Anschlusssystem für Stromzähler derart modular aufgebaut, dass der Anschluss des Stromzählers an die Plattform über eine gesonderte Baugruppe erfolgt. Wenn gemäß einer Ausführungsform der Erfindung die Basisplattform mehrere Sitze für die Aufnahme einer solchen Aufnahmebaugruppe aufweist, brauchen bei Nichtnutzung von Sitzen nicht alle Ankopplungselemente vorhanden zu sein. Erst bei einer Nachrüstung werden diese Elemente ergänzt.

Zweckmäßig sind die Anschlussleiter nicht sichtbar hinter der Basisplattform verlegt. Die Basisplattform kann einen zur Bildung eines Sitzes ausbrechbaren oder abnehmbaren Teil aufweisen, wobei ein Sitz z.B. durch einen Durchbruch oder eine Vertiefung in der Plattform gebildet sein kann.

In einer besonders bevorzugten Ausführungsform der Erfindung ist die Aufnahmebaugruppe sowohl von der Rückseite als auch der Vorderseite der Basisplattform her an der Basisplattform montierbar. Zweckmäßig ist eine einrastende Steckverbindung vorgesehen, die eine schnelle Montage ohne Werkzeug ermöglicht.

Die Möglichkeit zur Montage der Aufnahmebaugruppe von der Rückseite der Plattform her ist für die Produktion vorteilhaft, insbesondere dann, wenn gemäß einer Ausführungsform der Erfindung die Aufnahmebaugruppe mit in Anschlussräume zu führenden Anschlussleitern vorgefertigt ist. Die hinter der Basisplattform verlegten Anschlussleiter brauchen dann nicht eingefädelt zu werden. Die Montagemöglichkeit von der Vorderseite her erleichtert Nachrüstungen von Zählern und Aufnahmebaugruppen wie auch den Austausch von Zählern, z.B. zur Umstellung auf einen höheren Grenzstrom.

In weiterer Ausgestaltung der Erfindung kann es sich bei den Anschlussleitern um wenigstens teilweise starre, der Anschlussgeometrie entsprechend vorgeformte Leiter handeln. Letztere lassen sich nur montieren, wenn auch die Montagemöglichkeit von der Rückseite der Basisplattform her gegeben ist.

Die mit der Aufnahmebaugruppe vorgefertigten starren Leiter können mit einer Klemmleiste, insbesondere einer Hauptleitungsabzweigklemme verbunden sein, wobei die Klemmleiste entweder an die Basisplattform oder/und eine Hutprofilschiene in einem Anschlussraum koppelbar sein kann.

Die starren Anschlussleiter können ferner ein mit einem weiteren Anschlussleiter verbindbares Kontaktstück der genannten Klemmleiste bilden, was die Konstruktion der Klemmleiste vorteilhaft vereinfacht.

Die starren Leiter können unmittelbar in Kontakt mit einem Kontaktstück des Stromzählers stehen. Gesonderte Anschlusskontaktstücke für die Anschlussleiter an der Aufnahmebaugruppe sind dann überflüssig.

Die Aufnahmebaugruppe lässt sich sowohl mit nach oben als auch nach unten von der Baugruppe wegführenden Leitern vorfertigen.

In weiterer Ausgestaltung der Erfindung ist ein Nullleiter ununterbrochen durch die Aufnahmebaugruppe hindurch verlegt und innerhalb der Aufnahmebaugruppe, ggf. durch eine Messerkontaktierung, angeschlossen. Auch hierbei kann es sich um einen wenigstens teilweise starren Leiter handeln, der unmittelbar in Kontakt mit einem Kontaktstück des Zählers kommt. Gesonderte Anschlusselemente entfallen.

In weiterer vorteilhafter Ausgestaltung der Erfindung sind Einrichtungen zur Sicherung der Aufnahmebaugruppe in ihrer Montagestellung auf der Basisplattform vorgesehen. Eine solche Sicherung kann durch einen Teil des Stromzählers, z.B. ein Verhakungselement, gebildet sein. Ein die Steckverbindung bildendes Element umfasst zweckmäßig Einrichtungen zur Demontage der Aufnahmebaugruppe, wobei das Element zweckmäßig durch den in seiner Betriebsstellung plombierten Stromzähler versperrt und daher nicht zugänglich ist.

Auch ein die Rastverbindung bildendes Element kann Einrichtungen zur Lösung der Rastverbindung aufweisen.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: eine Schemadarstellung einer Zählerschrankinstallation mit einem Anschlusssystem gemäß der Erfindung,
- Fig. 2: eine schematische Querschnittsansicht A-A gemäß einem ersten Ausführungsbeispiel für ein Anschlusssystem nach der Erfindung,
- Fig. 3: eine dem Anschlusssystem von Fig. 2 zugehörige Basisplattform vor der Installation eines Stromzählers,
- Fig. 4: Details des Anschlusssystems von Fig. 2 und 3,
- Fig. 5: ein zweites Ausführungsbeispiel für ein Anschlusssystem nach der Erfindung, und
- Fig. 6: einen direkten Anschluss eines Nullleiters an ein Kontaktstück eines Stromzählers.

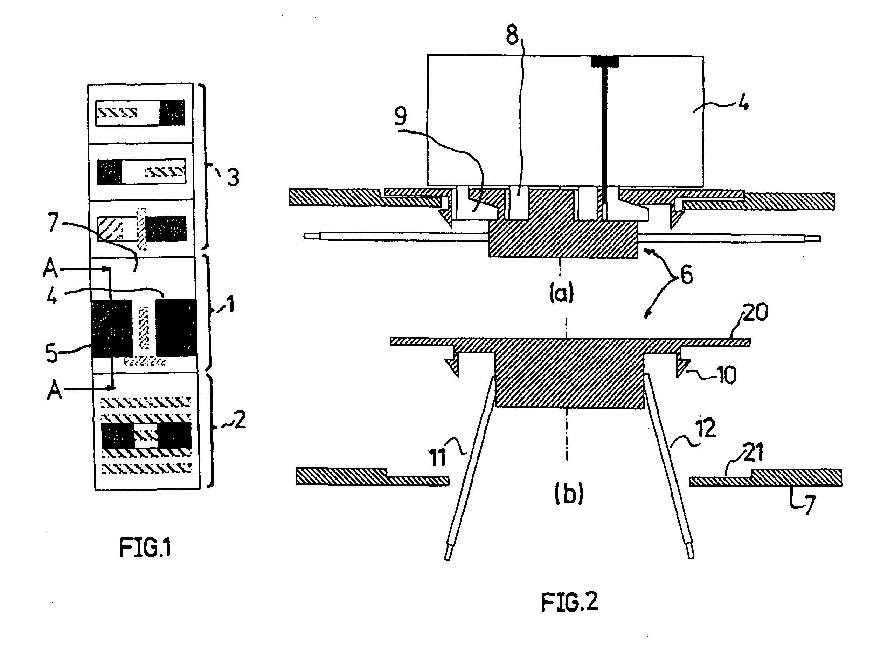

Eine in Fig. 1 gezeigte Zählerschrankinstallation weist einen ein Anschlusssystem für Stromzähler enthaltenden Abschnitt 1 sowie einen unteren und oberen Anschlussraum bildende Abschnitte 2 und 3 auf.

In dem Abschnitt 1 bestehen in dem betrachteten Fall Anschlussmöglichkeiten für zwei Stromzähler 4 und 5.

Aus der dem Schnitt A-A von Fig. 1 entsprechenden Darstellung von Fig. 2 ist erkennbar, dass der Stromzähler 4 mit einer Aufnahmebaugruppe 6 verbindbar ist, die ihrerseits mit einer Basisplattform 7 verbunden werden kann.

Während der Stromzähler 4 über von seiner Rückseite vorstehende Kontaktstücke 8 elektrisch und über Hakenelemente 9 mechanisch mit der Aufnahmebaugruppe 6 verbunden werden kann, ist die Aufnahmebaugruppe 6 auf die Basisplattform 7 aufsteckbar, wobei hinterschnittene Rastnasen 10 an der Basisplattform einrasten und Verlängerungen 20 der Aufnahmebaugruppe 6 in Randeinsenkungen 21 der Basisplattform eingreifen.

Zur elektrischen und mechanischen Verbindung mit der Aufnahmebaugruppe 6 ist der Zähler 4 parallel zur Basisplattform zu verschieben, wobei die Kontaktstücke 8 in elektrischen Kontakt mit innerhalb der Aufnahmebaugruppe vorgesehenen Anschlusselementen kommen und die Hakenelemente 9 Teile des Gehäuses der Aufnahmebaugruppe 6 hintergreifen, so dass der Zähler in Richtung senkrecht zur Basisplattform nicht mehr von der Aufnahmebaugruppe 6 abhebbar ist.

Die Aufnahmebaugruppe 6 ist komplett vorgefertigt mit hinter der Basisplattform 7 zu verlegenden, flexiblen Anschlussleitern 11 und 12, wobei die Anschlussleiter 11 in den oberen Anschlussraum und die Leiter 12 in den unteren Anschlussraum zu führen sind.

Für den Anschluss des Zählers 5 ist ein dem Anschlusssystem von Fig. 2 entsprechendes System vorgesehen.

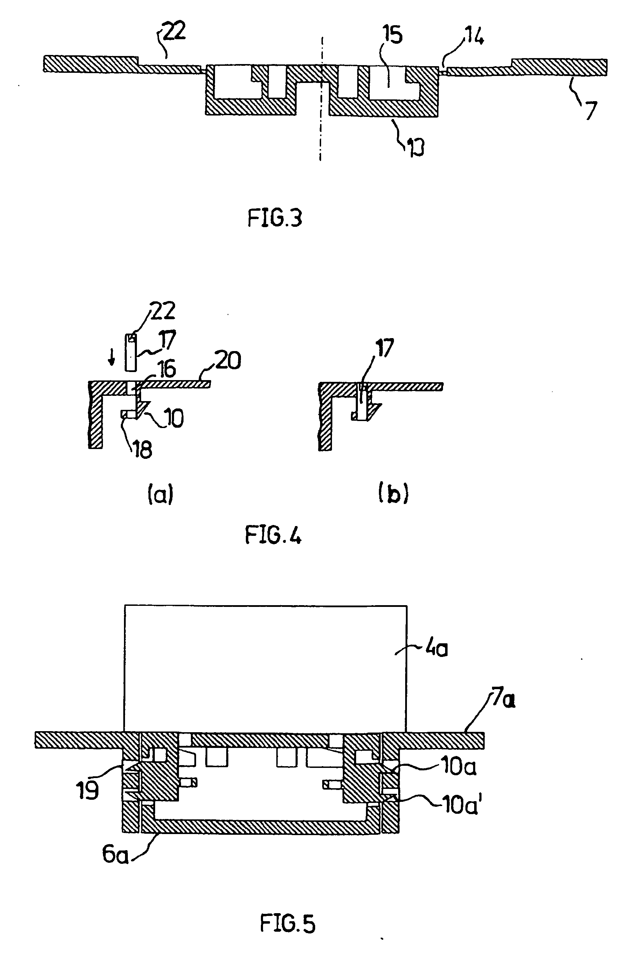

Wie aus Fig. 3 hervorgeht, weist die Basisplattform 7 ein plattenartiges Teil 13 auf, das über Schwachstellen 14 mit der übrigen Basisplattform verbunden und zur Bildung eines Sitzes für den Zähler 4 bzw. 5 aus der Basisplattform 7 ausbrechbar ist. In dem Teil 13 vorgesehene Räume 15 dienen einerseits der Meidung von Materialhäufungen und können andererseits vor Installation eines Stromzählers zur Unterbringung von Teilen, ggf. Verbindungselementen und dergleichen, genutzt werden.

Aus Fig. 4 gehen in Fig. 2 und 3 nicht sichtbare Details hervor. An wenigstens einer der Rastnasen 10 ist ein Durchgang 16 für die Aufnahme eines Sicherungsstifts 17 gebildet, welcher verhindert, dass sich die Rastnasen verbiegen und sich die Aufnahmebaugruppe auf ihrer eingerasteten Steckverbindung mit der Basisplattform 7 lösen kann. Wie Fig. 2a erkennen lässt, ist dieser Sicherungsstift 17 durch den in seiner Betriebslage zu plombierenden Zähler 4 abgedeckt und daher nicht zugänglich. Zur Demontage der Aufnahmebaugruppe 6 von der Basisplattform 7 kann ein einen Teil des Durchgangs 16 bildender Ansatz 18 an der Rastnase 10 dazu verwendet werden, die Rastnase aus ihrer Verhakungsstellung mit der Basisplattform 7 zu lösen, indem z.B. in den betreffenden Abschnitt des Durchgangs 16 ein Werkzeug eingeführt wird. Eine gestufte Ausnehmung 22 am Sicherungsstift kann zum Herausziehen des Stifts aus dem Durchgang 16 genutzt werden.

Es wird nun auf Fig. 5 Bezug genommen, wo gleiche oder gleichwirkende Teile mit derselben Bezugszahl wie in Fig. 2 und 3 bezeichnet sind, wobei der betreffenden Bezugszahl der Buchstabe a beigefügt ist.

Eine kastenartige Aufnahmebaugruppe 6a weist mehrere Paare vorstehender Rastnasen 10a und 10a' auf, die in Ausnehmungen 19 in einer Abwinklung an einer Basisplattform 7a eingreifen. Wie Fig. 5 erkennen lässt, weisen die Rastnasen in entgegengesetzten Richtungen geneigte Schrägen auf, so dass die Aufnahmebaugruppe 6 sowohl von der Vorderseite der Plattform 7a her als auch von deren Rückseite aus auf die Basisplattform aufsteckbar sind.

Die Montage des Zählers 4a an der Aufnahmebaugruppe erfolgt in gleicher Weise wie bei dem Ausführungsbeispiel von Fig. 2.

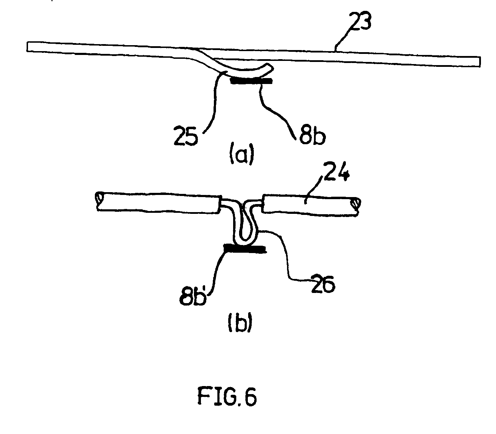

Fig. 6 zeigt durch eine Baugruppe hindurch verlegte Nullleiter 23 und 24. Eine ausgebogene Nase 25 des Leiters 23 liegt federnd gegen ein Kontaktstück 8b eines Stromzählers an.

Der in Fig. 6b gezeigte Leiter 24 ist flexibel und liegt mit einer Schleife 26 gegen ein Kontaktstück 8b' eines Stromzählers an.

## Patentansprüche

1. Anschlusssystem für elektronische Stromzähler (4,5) mit einer Basisplattform (7) und einer an der Basisplattform als Gesamtheit montierbaren Aufnahmebaugruppe (6) für den Stromzähler (4,5), wobei die Aufnahmebaugruppe sämtliche zur elektrischen und mechanischen Ankopplung des Stromzählers (4,5) erforderlichen Elemente aufweist und der Stromzähler (4,5) über von seiner Rückseite vorstehende Kontaktstücke(8) elektrisch und über Hakenelemente (9) mechanisch unter Verschiebung parallel zur Basisplattform (7) mit der Aufnahmebaugruppe (6) verbindbar ist,
**dadurch gekennzeichnet,**
**dass** die Basisplattform (7) durch einen Abschnitt (1) einer Zählerschrankinstallation gebildet und der Abschnitt (1) zwischen weiteren, einen oberen und unteren Anschlussraum bildenden Abschnitten (2,3) der Zählerschrankinstallation angeordnet ist und dass ein Neutralleiter (23,24) ohne Unterbrechung durch die Aufnahmebaugruppe (6) hindurch geführt ist.

2. System nach Anspruch 1,
**dadurch gekennzeichnet,**
**dass** an die Aufnahmebaugruppe (6) geführte Anschlussleiter (11,12) hinter der Basisplattform verlegt sind.

3. System nach Anspruch 1 oder 2,
**dadurch gekennzeichnet,**
**dass** an der Basisplattform ein Sitz oder mehrere Sitze für die Aufnahme jeweils einer Aufnahmebaugruppe (6) gebildet ist bzw. sind.

4. System nach einem der Ansprüche 1 bis 3,
**dadurch gekennzeichnet,**
**dass** die Basisplattform (7) einen zur Bildung eines Sitzes ausbrechbaren oder abnehmbaren Teil (13) aufweist.

5. System nach Anspruch 3 oder 4,
**dadurch gekennzeichnet,**
**dass** der Sitz durch einen Durchbruch oder/und eine Vertiefung (21) in der Basisplattform (7) gebildet ist.

6. System nach einem der Ansprüche 1 bis 5,
**dadurch gekennzeichnet,**
**dass** die Aufnahmebaugruppe (6) mit in Anschlussräume (2,3) zu führenden Leitern (11,12) vorgefertigt ist.

7. System nach einem der Ansprüche 1 bis 6,
**dadurch gekennzeichnet,**
**dass** die Aufnahmebaugruppe (6,6a) von der Rückseite oder/und der Vorderseite der Basisplattform (7,7a) her an der Basisplattform montierbar ist.

8. System nach einem der Ansprüche 1 bis 7,
**dadurch gekennzeichnet,**
**dass** die Aufnahmebaugruppe (6) auf die Basisplattform (7), vorzugsweise einrastend, aufsteckbar ist.

9. System nach einem der Ansprüche 1 bis 8,
**dadurch gekennzeichnet,**
**dass** Einrichtungen (16,17) zur Sicherung der Aufnahmebaugruppe (6) in ihrer Montagestellung auf der Basisplattform (7) vorgesehen sind.

10. System nach Anspruch 9,
**dadurch gekennzeichnet,**
**dass** ein die Sicherungseinrichtungen bildendes Element Einrichtungen (18) zur Demontage der Aufnahmebaugruppe umfasst.

11. System nach einem der Ansprüche 8 bis 10,
**dadurch gekennzeichnet,**
**dass** ein die Rastverbindung bildendes Element (10) Einrichtungen (18) zur Lösung der Rastverbindung aufweist.

12. System nach einem der Ansprüche 1 bis 11,
**dadurch gekennzeichnet,**
**dass** die Aufnahmebaugruppe mit wenigstens teilweise starren, der Anschlussgeometrie entsprechend vorgeformten Anschlussleitern vorgefertigt ist.

13. System nach einem der Ansprüche 1 bis 12,
**dadurch gekennzeichnet,**
**dass** die Aufnahmebaugruppe (6) mit sowohl nach oben als auch nach unten von der Baugruppe wegführenden Leitern (11,12) vorgefertigt ist.

14. System nach einem der Ansprüche 1 bis 13,
**dadurch gekennzeichnet,**
**dass** ein Nullleiter innerhalb der Baugruppe ggf. durch eine Messerkontaktierung, kontaktiert ist.

15. System nach Anspruch 14,
**dadurch gekennzeichnet,**
**dass** der Nullleiter wenigstens teilweise starr ist und ggf. unmittelbar, vorzugsweise federnd, mit einem Kontaktstück des Stromzählers in Berührung kommt.

## Claims

1. Connection system for electronic electricity meters (4, 5) with a base platform (7) and a receiving assembly (6) to be mounted on the base platform as a complete unit for the electricity meter (4, 5), wherein the receiving assembly comprises all elements necessary for the electrical and mechanical coupling of the electricity meter (4, 5), and wherein the electricity meter (4, 5) can be electrically connected via contact pieces (8) projecting from its rear, and mechanically connected with the receiving assembly (6) via hook elements (9) when displaced parallel to the base platform (7),
**characterised in that** the base platform (7) is formed by a section (1) of a meter box installation and the section (1) is arranged between further sections (2, 3) of the meter box installation, forming an upper and a lower connection space, and **in that** a neutral conductor (23, 24) is routed through the receiving assembly (6) without interruption.

2. System according to claim 1, **characterised in that** connecting conductors (11, 12) routed to the receiving assembly (6) run behind the base platform.

3. System according to claim 1 or 2, **characterised in that** a seat or several seats for receiving a receiving assembly (6) each is or are formed on the base platform.

4. System according to one of the claims 1 to 3, **characterised in that** the base platform (7) comprises a part (13) that can be broken off or removed for forming a seat.

5. System according to claim 3 or 4, **characterised in that** the seat is formed by a breakout and/or a depression (21) in the base platform (7).

6. System according to one of the claims 1 to 5, **characterised in that** the receiving assembly (6) is pre-fabricated with conductors (11, 12) to be routed into connection spaces (2, 3).

7. System according to one of the claims 1 to 6, **characterised in that** the receiving assembly (6, 6a) can be mounted on the base platform the rear and/or the front of the base platform (7, 7a).

8. System according to one of the claims 1 to 7, **characterised in that** the receiving assembly (6) can be pushed onto the base platform (7), and preferably arrested on the same.

9. System according to one if the preceding claims 1 to 8, **characterised in that** means (16, 17) for securing the receiving assembly (6) in its mounting position are provided on the base platform (7).

10. System according to claim 9, **characterised in that** an element forming the securing means comprises means (18) for disconnecting the receiving assembly.

11. System according to one of the claims 8 to 10, **characterised in that** an element (10) forming the arresting connection comprises means (18) for disconnecting the arresting connection.

12. System according to one of the claims 1 to 11, **characterised in that** the receiving assembly is pre-fabricated with at least partially rigid pre-formed connecting conductors that correspond to the connection geometry.

13. System according to one of the claims 1 to 12, **characterised in that** the receiving assembly (6) is pre-fabricated with conductors (11, 12) leading upwards as well as downwards away from the assembly.

14. System according to one of the claims 1 to 13, **characterised in that** a zero conductor is contacted inside the assembly, possibly by means of a blade contact.

15. System according to claim 14, **characterised in that** the zero conductor is at least partially rigid and contacts a contact piece of the electricity meter, possibly directly, preferably flexibly.

## Revendications

1. Système de raccordement pour des compteurs d'électricité électroniques (4, 5), avec une plate-forme de base (7) et avec un sous-ensemble de réception (6) pouvant être monté en tant que tout sur la plate-forme de base et destiné à recevoir le compteur d'électricité (4, 5), le sous-ensemble de réception présentant tous les éléments nécessaires pour l'accouplement électrique et mécanique du compteur d'électricité (4, 5) et le compteur d'électricité (4, 5) pouvant, par un déplacement parallèlement à la plate-forme de base (7), être relié au sous-ensemble de réception (6) électriquement au moyen de pièces de contact (8) dépassant de son côté arrière et mécaniquement au moyen d'éléments d'accrochage (9),
**caractérisé en ce que** la plate-forme de base (7) est formée par une partie (1) d'un boîtier d'installation de compteurs et la partie (1) est disposée entre d'autres parties (2, 3) du boîtier d'installation de compteurs qui forment un compartiment de raccordement supérieur et un compartiment de raccordement inférieur, et **en ce qu'**un conducteur neutre (23, 24) est dirigé sans interruption à travers le sous-ensemble de réception (6).

2. Système selon la revendication 1, **caractérisé en ce que** des conducteurs de raccordement (11, 12) amenés au sous-ensemble de réception (6) sont posés derrière la plate-forme de base.

3. Système selon la revendication 1 ou 2, **caractérisé en ce qu'**une ou plusieurs assises destinées à recevoir chacune un sous-ensemble de réception (6) est ou sont formée(s) sur la plate-forme de base.

4. Système selon l'une des revendications 1 à 3, **caractérisé en ce que** la plate-forme de base (7) présente une partie (13) pouvant être brisée ou retirée pour former une assise.

5. Système selon la revendication 3 ou 4, **caractérisé en ce que** l'assise est formée par une brèche et/ou un renfoncement (21) dans la plate-forme de base (7).

6. Système selon l'une des revendications 1 à 5, **caractérisé en ce que** le sous-ensemble de réception (6) est préfabriqué avec des conducteurs (11, 12) à amener dans les compartiments de raccordement (2, 3).

7. Système selon l'une des revendications 1 à 6, **caractérisé en ce que** le sous-ensemble de réception (6, 6a) peut être monté sur la plate-forme de base (7, 7a) par le côté arrière et/ou par le côté avant de la plate-forme de base.

8. Système selon l'une des revendications 1 à 7, **caractérisé en ce que** le sous-ensemble de réception (6) peut être emboîté sur la plate-forme de base (7), de préférence par encliquetage.

9. Système selon l'une des revendications 1 à 8, **caractérisé en ce qu'**il est prévu des organes (16, 17) pour assujettir le sous-ensemble de réception (6) dans sa position de montage sur la plate-forme de base (7).

10. Système selon la revendication 9, **caractérisé en ce qu'**un élément formant les organes d'assujettissement comprend des organes (18) pour le démontage du sous-ensemble de réception.

11. Système selon l'une des revendications 8 à 10, **caractérisé en ce qu'**un élément (10) formant la liaison par encliquetage présente des organes (18) pour défaire la liaison par encliquetage.

12. Système selon l'une des revendications 1 à 11, **caractérisé en ce que** le sous-ensemble de réception est préfabriqué avec des conducteurs de raccordement au moins partiellement rigides, préformés conformément à la géométrie de raccordement.

13. Système selon l'une des revendications 1 à 12, **caractérisé en ce que** le sous-ensemble de réception (6) est préfabriqué avec des conducteurs (11, 12) partant du sous-ensemble tant vers le haut que vers le bas.

14. Système selon l'une des revendications 1 à 13, **caractérisé en ce qu'**un conducteur neutre est mis en contact à l'intérieur du sous-ensemble, éventuellement par une mise en contact à couteaux.

15. Système selon la revendication 14, **caractérisé en ce que** le conducteur neutre est au moins partiellement rigide et entre en contact éventuellement directement, de préférence élastiquement, avec une pièce de contact du compteur d'électricité.
